# EUROPÄISCHE PATENTSCHRIFT

(11) **EP 3 825 003 B1**
(45) Veröffentlichungstag und Bekanntmachung des Hinweises auf die Patenterteilung: **01.06.2022**
(21) Anmeldenummer: 19210724.1
(22) Anmeldetag: 21.11.2019
(51) Int. Cl.: B01L 3/00, H01L 21/02, B81C 1/00

(54) **VERFAHREN ZUR FERTIGUNG EINER MIKROFLUIDISCHEN VORRICHTUNG**
METHOD FOR MANUFACTURING A MICROFLUIDIC DEVICE
PROCÉDÉ DE FABRICATION D'UN DISPOSITIF MICROFLUIDIQUE

(43) Veröffentlichungstag der Anmeldung: 26.05.2021
(73) Patentinhaber: IMT AG, 8606 Greifensee (CH)
(72) Erfinder: BAUERT, Tobias, 8486 Rikon im Tösstal (CH); GROGG, Daniel, 8626 Ottikon (CH)
(74) Vertreter: Maikowski & Ninnemann Patentanwälte Partnerschaft mbB

(56) Entgegenhaltungen:
- US-A1- 2019 143 321
- US-B1- 6 180 536
- US-B1- 8 563 325

## Beschreibung

Diese Schrift betrifft Ausführungsformen von Verfahren zur Fertigung einer mikrofluidischen Vorrichtung.

Mikrofluidische Vorrichtungen sind ausgebildet, Fluide, insbesondere Flüssigkeiten, in Strukturen, die wenigstens teilweise Abmessungen im Mikrometerbereich (wie von wenigen Mikrometern bis zu einigen hundert Mikrometer) haben, aufzunehmen und/oder zu leiten. Beispielsweise werden mikrofluidische Vorrichtungen in Form von sogenannten "Lab-on-a-Chip"-Systemen für medizintechnische oder allgemein biotechnologische Anwendungen eingesetzt. Derartige mikrofluidischen Vorrichtungen werden dementsprechend manchmal auch als Mikrofluidik-Chips bezeichnet. Es ist ferner bekannt, mikrofluidische Vorrichtungen in Form von sogenannten "Flow cells" z. B. für diagnostische Zwecke und speziell für die DNA-Sequenzierung zu verwenden.

Üblicherweise umfasst eine solche mikrofluidische Vorrichtung ein erstes Substrat, z. B aus Glas, Quartz oder Silizium, mit einer Oberfläche, in welcher eine oder mehrere Vertiefungen vorgesehen sind, wobei die Vertiefung(en) ein oder mehrere Kavitäten und/oder Kanäle ausbilden. Dabei können in den Kavitäten und/oder Kanälen entsprechend der jeweiligen Funktion der mikrofluidischen Vorrichtung geeignete Chemikalien, Elektroden etc. angeordnet sein.

Nach oben hin sind die Kavitäten und/oder Kanäle zumeist durch einen "Deckel" in Form eines zweiten Substrats abgeschlossen.

Dabei sind im Rahmen der vorliegenden Beschreibung Angaben wie "nach oben", "oberer", "auf, "nach unten", "unterer" etc. lediglich relative Angaben, die bei einmal festgelegten Bezugssystem räumliche Beziehungen verschiedener Komponenten zueinander bezeichnen, aber keine absolute Orientierung im Raum festlegen.

Der Abschluss der Kavitäten und/oder Kanäle durch das zweite Substrat muss insbesondere (wenigstens abschnittsweise) fluiddicht sein. In der Anwendung kann dann z. B. ein Analyt durch die Kanäle gedrückt und die entsprechende Analytik ausgeführt werden.

Das erste Substrat und/oder das zweite Substrat können in Form eines Wafers (z. B. aus Glas oder Silizium) bzw. als Teil eines solchen Wafers bereitgestellt sein. In diesem Fall können die beiden Wafer beispielsweise durch sogenanntes Waferbonden aufeinander geklebt werden, wodurch der Kanal in dem Fluidleitungsteil mittels des Verschlussteils nach oben verschlossen wird.

Beispielsweise wird beim sogenannten Klebebonden mittels eines dünnen Klebstofffilms eine flächige Verbindung zwischen zwei Wafern (wie z. B. Glaswafern) geschaffen. Diese Form der Verbindungstechnik wird insbesondere bei Komponenten eingesetzt, die in nachfolgenden Prozessschritten keinen erhöhten Temperaturen ausgesetzt werden dürfen, z. B. weil bereits Metalle oder biologische Funktionsstrukturen vorhanden sind, welche kein höheres Temperaturbudget vertragen.

Als Alternative zum Klebebonden ist ferner bekannt, eine Oberfläche des zweiten Substrats mittels Direktbonden (auf Englisch: "direct bonding" oder "fusion bonding") an der Oberfläche des zweiten Substrats zu befestigen. Ein solches Verfahren kommt ohne Klebstoff oder andere Zwischenschichten aus. Stattdessen beruht die Befestigung auf chemischen Bindungen zwischen den Oberflächen, wie z. B van der Waals-Kräften, Wasserstoffbindungen oder starken kovalenten Bindungen.

Voraussetzung dafür ist, dass die beteiligten Oberflächen hinreichen sauber, flach, und glatt sind. Insbesondere dürfen die Oberflächen keine zu großen Partikel oder Vorsprünge aufweisen. Mit anderen Worten müssen die Oberflächen eine äußerst geringe Oberflächenrauheit, beispielsweise von weniger als 0,5 nm, aufweisen, um das Direktbonden zu ermöglichen. Jeder Partikel mit einem Partikeldurchmesser von 0,5 nm oder mehr kann zu kontaktfreien Stellen (auch als Fehlstellen oder "Voids" bezeichnet) zwischen den beteiligten Oberflächen führen, wobei ein Durchmesser der kontaktfreien Stellen üblicherweise um etwa einen Faktor 10.000 größer als der Partikeldurchmessers ist. So kann beispielsweise ein 100 nm Partikel mit einem Partikeldurchmesser von 100 nm zu einem Void mit Durchmesser von ca. 1 mm führen.

Aufgrund der vorstehend beschriebenen hohen Anforderungen an die Eigenschaften der Substratoberflächen ist ein Direktbonden von Wafern, insbesondere Glaswafern, mit strukturierten Oberflächen am Bond-Interface im Allgemeinen nicht möglich. In solchen Fällen wird daher üblicherweise auf alternative Bond-Technologien, wie z. B. das vorstehend erwähnte Klebebonden, zurückgegriffen, die in der Lage sind, die Stufen der Strukturen zu begraben oder anderweitig zu verhindern, dass sich um die Strukturen herum Voids ausbilden.

Bei mikrofluidischen Vorrichtungen werden jedoch mitunter elektrisch leitfähige Strukturen im Bereich einer Oberfläche des ersten Substrats funktional, z. B. als metallische Elektroden, benötigt. Es ist wünschenswert, dennoch ein Direktbonden mit der Oberfläche eines zweiten Substrats zu ermöglichen.

Aus der US 5,525,190 A ist ein Fertigungsverfahren für einen optischen Wellenleiter bekannt, bei welchem in einer Oberfläche eines Substrats ausgebildete Kanäle von Innen mit einer reflektierenden Metallschicht versehen werden. Dabei wird die Metallschicht zunächst ganzflächig auf die Oberfläche und sowie auf Kanalböden und -wände abgeschieden. Anschließend wird das abgeschiedene Metall von der Oberfläche abgeschliffen, sodass es nur in den Kanälen stehen bleibt und dementsprechend strukturiert wird. Eine derartige Vorgehensweise würde jedoch, wenn sie auf die Erzeugung metallischer Strukturen in mikrofluidischen Vorrichtungen übertragen würde, nicht ohne Weiteres zu einer hinreichend glatten Oberfläche führen, welche ein Direktbonden mit einem weiteres Substrat zulassen würde. Daher wären ggf. aufwendige Schleif- und/oder Polierprozesse nötig, um die Voraussetzungen für ein Direktbonden zu schaffen.

Weitere mikrofluidische Vorrichtungen sind aus der US 6 180 536 B1 sowie aus der US 8 563 325 B1 bekannt.

Die vorliegende Erfindung stellt sich die Aufgabe, ein möglichst kosteneffizientes Verfahren zur Fertigung einer mikrofluidischen Vorrichtung bereitzustellen, bei welchem elektrisch leitfähige Strukturen im Bereich einer Oberfläche eines ersten Substrats angeordnet werden. Dabei soll das Verfahren jedenfalls prinzipiell mit einem Direktbonden der Oberfläche an ein zweites Substrat vereinbar sein, d. h., es soll insbesondere zu einer hinreichend glatten Oberfläche führen können.

Des Weiteren wird eine entsprechende mikrofluidische Vorrichtung vorgeschlagen, die mit einem solchen Verfahren fertigbar ist.

Die vorliegende Erfindung ist durch den unabhängigen Anspruch 1 definiert. Merkmale einiger Ausführungsbeispiele sind in den Unteransprüchen angegeben. Die Merkmale der Unteransprüche können miteinander zur Ausbildung weiterer Ausführungsformen kombiniert werden, sofern nicht ausdrücklich etwas anderes angegeben ist.

Gemäß einem ersten Aspekt wird ein Verfahren zur Fertigung einer mikrofluidischen Vorrichtung vorgeschlagen. Das Verfahren umfasst zunächst die folgenden Schritte: Bereitstellen eines ersten Substrats mit einer ersten Oberfläche und einer der ersten Oberfläche gegenüberliegenden zweiten Oberfläche; Erzeugen einer Ätzmaske auf der ersten Oberfläche, wobei die Ätzmaske eine Öffnung aufweist; Erzeugen, mittels einer Ätzung, einer Vertiefung in der ersten Oberfläche im Bereich der Öffnung. Dabei umfasst das Verfahren ferner das Abscheiden eines elektrisch leitfähigen Materials auf die Ätzmaske und/oder eine die Ätzmaske bedeckende Schicht sowie auf einen Bereich eines Bodens der Vertiefung unterhalb der Öffnung.

Das Verfahren gemäß dem ersten Aspekt umfasst dabei vor dem Abscheiden des elektrisch leitfähigen Materials die folgenden Schritte: Auftragen eines Fotolacks auf die Ätzmaske und auf einen Bereich eines Bodens der Vertiefung unterhalb der Öffnung; und Entfernen des Fotolacks aus der Vertiefung. Das elektrisch leitfähige Material wird auf den die Ätzmaske bedeckenden Fotolack und auf einen Bereich eines Bodens der Vertiefung unterhalb der Öffnung abgeschieden. Dabei wird das elektrisch leitfähige Material insbesondere auf den Bereich des Bodens der Vertiefung abgeschieden, von welchem in dem vorherigen Verfahrensschritt der Fotolack entfernt worden ist.

Bevorzugt wird die Ätzmaske beim Erzeugen der Vertiefung wenigstens teilweise seitlich unterätzt, sodass wenigstens ein seitlicher Randabschnitt der Ätzmaske über einen Rand der Vertiefung hinaus übersteht.

Das erste Substrat liegt bevorzugt in Form eines Wafers, z. B. aus Glas, vor. Dabei kann die erste Oberfläche z. B. ein Abschnitt einer vorderseitigen Waferoberfläche (Wafervorderseite) sein. Die zweite Oberfläche kann dementsprechend ein Abschnitt einer rückseitigen Waferoberfläche (Waferrückseite) sein.

Nicht Teil der Erfindung ist eine mikrofluidische Vorrichtung, welche mittels eines Verfahrens gemäß dem ersten Aspekt gefertigt worden ist.

Nicht Teil der Erfindung ist eine mikrofluidische Vorrichtung umfassend ein erstes Substrat mit einem darin ausgebildeten Kanal, wobei in dem Kanal ein elektrisch leitfähiges Material angeordnet ist, und wobei ein Boden des Kanals in einem Querschnitt seitliche Rundungen, insbesondere in Form von Ätzradien, aufweist. Dabei ist der Kanal im Bereich der Rundungen frei von dem elektrisch leitfähigen Material.

Beispielsweise kann eine derartige mikrofluidische Vorrichtung mittels eines Verfahrens gemäß dem ersten Aspekt gefertigt worden sein.

Nachstehend wird auf alle vorstehend genannten Aspekte Bezug genommen werden.

Die Erfindung löst die Aufgabe, indem passend zu den zu erzeugenden leitfähigen Strukturen eine oder mehrere Vertiefung(en), z. B. in Form eines oder mehrerer Kanäle, in das erste Substrat geätzt werden. Die dabei verwendete strukturierte Ätzmaske bleibt nach dem Ätzen des Kanals stehen. Hierdurch werden die nachfolgenden Prozessschritte zur Erzeugung der elektrisch leitfähigen Strukturen selbstausrichtend. Insbesondere können nachfolgende Beschichtungsprozesse ganzflächig auf einem Wafer ausgeführt werden, ohne dass eine gezielte Justierung bezüglich der geätzten Vertiefung(en) erfolgen muss.

Das vorgeschlagene selbstausrichtende Verfahren ist sowohl robust als auch kosteneffizient. Ein weiterer wesentlicher Vorteil des vorgeschlagenen Verfahrens ist, dass auf diese Weise ein Direktbonden auch mit (in Vertiefungen versenkten) metallischen Elektroden am Bond-Interface möglich wird.

Bei einer gefertigten mikrofluidischen Vorrichtung kann sich die Verwendung des selbstausrichtenden Verfahrens insbesondere am Fehlen von metallisch leitfähigem Material in den Ätzradien der isotrop geätzten Vertiefung(en) zeigen.

Gemäß einer Ausführungsform umfasst das Entfernen des Fotolacks aus der Vertiefung eine Belichtung des Fotolacks in der Vertiefung. Dabei kann eine Belichtung durch die zweite Oberfläche hindurch, d.h. beispielsweise von der Waferrückseite her, erfolgen.

Das erste Substrat ist dabei vorzugsweise für Licht, das für eine Belichtung des Fotolacks geeignet ist, transparent. So wird es ermöglicht, dass der Fotolack in der Vertiefung durch eine Flutbelichtung durch die zweite Oberfläche hindurch belichtet wird.

Demgegenüber kann vorgesehen sein, dass die Ätzmaske für Licht, das für eine Belichtung des Fotolacks verwendet wird, intransparent ist. So wird bei einer Flutbelichtung durch die zweite Oberfläche hindurch der Fotolack auf der Ätzmaske nicht belichtet.

Auf diese Weise kann durch eine Belichtung von der Rückseite her sowie eine anschließende Entwicklung der Fotolack gezielt aus der Vertiefung entfernt werden, wohingegen der Fotolack vorderseitig auf der Ätzmaske stehen bleibt.

Gemäß einer vorteilhaften Ausführungsform wird bei der Abscheidung eine Schichtdicke des elektrisch leitfähigen Materials in der Vertiefung so gewählt, dass sie kleiner als eine Tiefe der Vertiefung ist. Dies erlaubt später ein Direktbonden der ersten Oberfläche mit der Oberfläche eines zweiten Substrats, ohne dass das elektrisch leitfähige Material im Weg steht.

Gemäß einer bevorzugten Ausführungsform ist die Vertiefung ein Kanal mit einer Tiefe im Bereich von 0,01 µm bis 5,0 µm, bevorzugt im Bereich von 0,1 µm bis 1,0 µm, wie z.B. 0,5 µm.

Alternativ oder zusätzlich kann vorgesehen sein, dass die Vertiefung ein Kanal mit einer Breite im Bereich von 1 µm bis 5000 µm, bevorzugt im Bereich von 1 µm bis 500 µm ist, wie z.B. 100 µm, ist.

In einer Weiterbildung umfasst das vorgeschlagene Verfahren ferner das Entfernen der Ätzmaske. Dies kann je nach dem Material der Ätzmaske z.B. durch eine Ätzung bewerkstelligt werden. Wird für die Ätzmaske beispielsweise Chrom als Material verwendet, so kann die Ätzmaske mittels einer Chromätzung entfernt werden.

Es kann ferner vorgesehen sein, dass die erste Oberfläche eine Oberflächenrauheit von weniger als 0,5 nm aufweist. Hierdurch wird ein zuverlässiges Direktbonden der ersten Oberfläche an eine Oberfläche eines zweiten Substrats, etwa in Form eines zweiten Wafers, möglich.

Es liegt nämlich auch im Rahmen der Erfindung, dass in einem weiteren Verfahrensschritt ein zweites Substrat mittels Waferbonden, insbesondere Direktbonden, an der ersten Oberfläche befestigt werden kann.

In einer Ausführungsvariante kann dabei eine Oberfläche des zweiten Substrats eine Vertiefung aufweisen, wobei die Oberfläche des zweiten Substrats derart an der ersten Oberfläche befestigt wird, dass die Vertiefung des ersten Substrats und die Vertiefung des zweiten Substrats einander gegenüberliegen. So kann beispielsweise, wenn eine versenkte Metallelektrode auf dem ersten Substrat und ein Mikrofluidikkanal auf dem zweiten Substrat untergebracht wird, ein direkter Kontakt zwischen einem Medium (Fluid) in dem Mikrofluidikkanal und der Metallelektrode hergestellt werden.

Als Materialien für das erste Substrat und/oder das zweite Substrat kommen bevorzugt Glas, Quartz oder Silizium in Frage. Insbesondere Glaswafer eignen sich für die vorstehend erläuterte Herstellungsvariante einer mikrofluidischen Vorrichtung mittels Waferbonden.

Auch eine mikrofluidische Vorrichtung kann insbesondere mittels eines Verfahrens entsprechend dem ersten Aspekt hergestellt worden sein. Dementsprechend sind die vorstehenden und nachfolgenden Erläuterungen mit Bezug auf das Verfahren gemäß dem ersten Aspekt analog auf die mikrofluidischen Vorrichtungen anwendbar - und umgekehrt.

Weitere Einzelheiten und Vorteile der Erfindung werden bei der nachfolgenden Beschreibung einiger Ausführungsbeispiele anhand der Figuren deutlich werden.

Es zeigen:
- Fig. 1A-H: schematisch und exemplarisch verschiedene Schritte und Zwischenstadien bei einem Verfahren zur Fertigung einer mikrofluidischen Vorrichtung gemäß einem oder mehreren Ausführungsbeispielen; und
- Fig. 2A-D: schematisch und exemplarisch verschiedene Schritte und Zwischenstadien bei einem Verfahren zur Fertigung einer mikrofluidischen Vorrichtung.

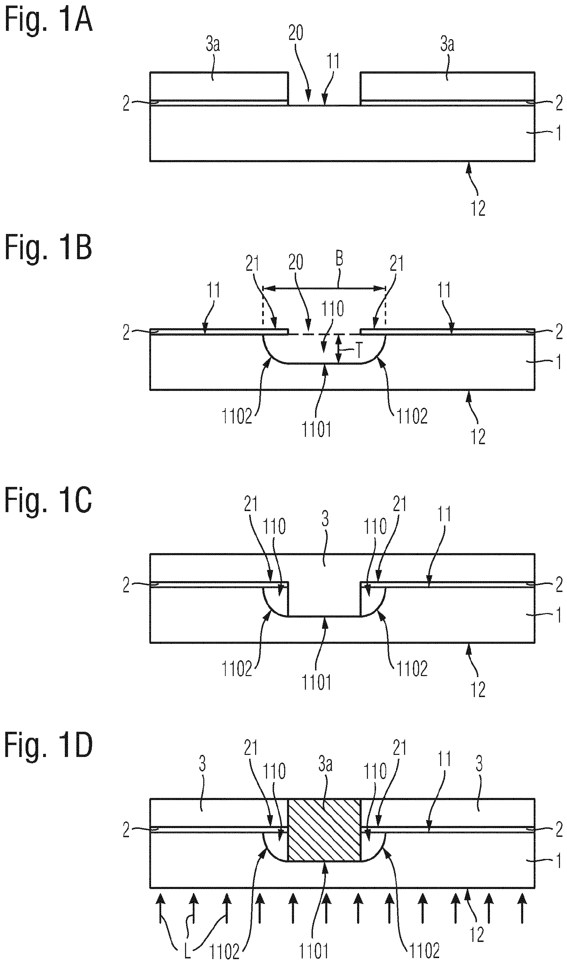

Zunächst wird ein erstes Substrats 1 mit einer ersten Oberfläche 11 und einer der ersten Oberfläche gegenüberliegenden zweiten Oberfläche 12 bereitgestellt (s. Fig. 1A).

Das erste Substrat 1 liegt bevorzugt in Form eines Wafers aus Glas vor. In einer alternativen Ausführungsvariante kann das erste Substrat 1 aber z. B. auch ein Wafer aus Silizium oder Quartz sein.

Dabei kann die erste Oberfläche 11 z. B. ein Abschnitt einer vorderseitigen Waferoberfläche (Wafervorderseite) sein. Die zweite Oberfläche 12 kann dementsprechend ein Abschnitt einer rückseitigen Waferoberfläche (Waferrückseite) sein.

Auf der ersten Oberfläche 11 wird sodann eine strukturierte Ätzmaske 2 erzeugt, die wenigstens eine Öffnung 20 aufweist. Bei der Ätzmaske 2 kann es sich um eine Hartmaske, wie z.B. eine Hartmaske aus Chrom, handeln. Die Ätzmaske 2 kann z. B. mittels an sich bekannter fotolithographischer Verfahren strukturiert werden. Dies ist in der Fig. 1A durch eine strukturierte Schicht aus Fotolack (Resist) 3a angedeutet.

Bei der in Fig. 1A dargestellten Querschnittsansicht ist eine entsprechende strukturierte Ätzung des Materials der Ätzmaske 2, beispielsweise Chrom, bereits erfolgt, wodurch die Öffnung 20 erzeugt worden ist.

Fig. 1B veranschaulicht, wie anschließend mittels einer Ätzung im Bereich der Öffnung 20 eine Vertiefung 110 in der ersten Oberfläche 11 erzeugt wird. Dabei wird mit einem Ätzmittel, wie z. B. HF oder KOH, das Material des ersten Substrats 1 (z. B. Glas) isotrop geätzt.

In der schematischen Querschnittsansicht gemäß Fig. 1B ist gut erkennbar, dass dabei die Ätzmaske 2 teilweise seitlich unterätzt wird, sodass seitliche Randabschnitte 21 der Ätzmaske 2 über einen Rand der Vertiefung 110 überstehen. Ferner wird anhand der Fig. 1B deutlich, dass ein Boden 1101 der Vertiefung 110 in einem Querschnitt seitliche Rundungen 1102 aufweist. Die seitlichen Rundungen 1102 sind Ätzradien, die bei der isotropen Ätzung entstehen.

Die so erzeugte Vertiefung 110 kann eine Kavität oder ein Kanal sein in welcher bzw. in welchem in der Folge z. B. eine metallische Elektrode angeordnet werden soll. Beispielsweise kann die Vertiefung 110 die Form eines Kanals mit einer Tiefe T von bis zu einigen hundert Nanometern haben, etwa im Bereich von 0,05 µm bis 5,0 µm, bevorzugt im Bereich von 0,1 µm bis 1,0 µm, wie z.B. 0,5 µm.. Eine Breite B des Kanals 110 kann z. B. im Bereich von 1 µm bis 5000 µm, bevorzugt im Bereich von 1 µm bis 500 µm, wie z.B. 100 µm, liegen.

Nach dem Ätzvorgang wird die Ätzmaske 2 zunächst nicht entfernt, sondern mitsamt den seitlich über die Vertiefung 110 überstehenden Randabschnitte 21 stehen gelassen. Hierdurch werden die nachfolgenden Prozessschritte zur Erzeugung einer elektrisch leitenden Struktur 4 in der Vertiefung 110 selbstausrichtend (Englisch: "self-aligned"), sodass beispielsweise einige Prozesse auf dem gesamten Wafer 1 ausgeführt werden können, ohne dass eine gezielte Ausrichtung an dem bereits geätzten Kanal 110 (bzw. falls vorhanden an mehreren derartigen Kanälen 110) vorgenommen werden muss.

Dies soll im Folgenden anhand der weiteren Figuren deutlich gemacht werden.

So kann die Waferoberfläche 1 in einem nachfolgenden Schritt erneut mit einem Fotolack 3, 3b beschichtet werden, beispielsweise mittels Spin-Coating. Im Ergebnis dieses Schritts bedeckt der Fotolack 3, 3b die Ätzmaske 2 sowie einen Bereich eines Bodens 1101 der Vertiefung 110 unterhalb der Öffnung 20, wie in Fig. 1C dargestellt. Die seitlichen Ätzradien 1102 unterhalb der überstehenden Randabschnitte 21 der Ätzmaske 2 bleiben hingegen von Fotolack 3, 3b frei.

Fig. 1D zeigt einen weiteren Schritt, in welchem der Fotolacks 3b aus der Vertiefung 110 entfernt wird. Dies wird in selbstausrichtender Weise mittels einer Belichtung und einer anschließenden Entwicklung des Fotolacks 3b in der Vertiefung 110 bewerkstelligt. Dabei erfolgt die (Flut-)Belichtung durch die zweite Oberfläche 12 hindurch, d. h. von der Rückseite her. In Fig. 1D ist dies durch vertikale Pfeile L, die nach oben weisen, angedeutet.

Da das Material des ersten Substrats 1 (z. B. Glas) das zur Belichtung des Fotolacks 3b verwendete Licht L transparent ist, das Material der Ätzmaske 2 (z. B. Chrom) hingegen für dieses Licht L intransparent ist, wird in selbstausrichtender Weise gezielt der Fotolack 3b aus der Vertiefung 110 entfernt. In Fig. 1D ist der belichtete Abschnitt des Fotolacks 3b schraffiert kenntlich gemacht. Auf der Ätzmaske 2 bleibt der Fotolack 3 hingegen stehen.

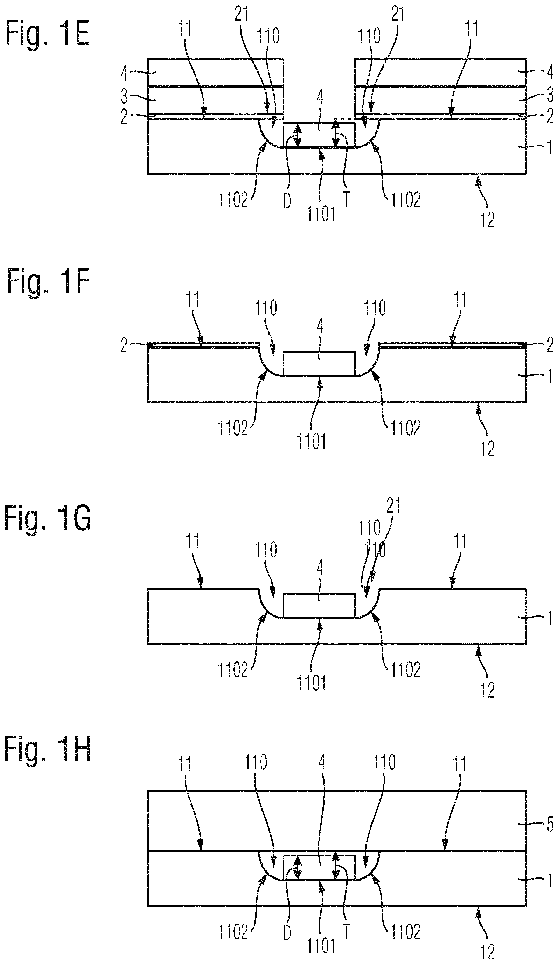

Auf den die Ätzmaske 2 bedeckenden Fotolack 3 und auf einen Bereich eines Bodens 1101 der Vertiefung 110 unterhalb der Öffnung 20, von dem zuvor der Fotolack 3b entfernt wurde, wird sodann ein elektrisch leitfähigen Material 4 abgeschieden. Beispielsweise kann in diesem Schritt eine metallische Schicht 4 (z. B. Gold) ganzflächig auf dem Wafer 1 abgeschieden werden. Dies ist schematisch in Fig. 1E veranschaulicht.

Die Abscheidung wird bevorzugt in der Weise ausgeführt, dass eine resultierende Schichtdicke D des elektrisch leitfähigen Materials 4 in der Vertiefung 110 nicht größer als eine Tiefe T der Vertiefung 110 ist. Dadurch wird garantiert, dass das elektrisch leitfähige Material 4 nicht aus der Vertiefung 110 über die ursprüngliche erste Oberfläche 11 hinaus übersteht und dass ein späteres Direktbonden oder andere Verfahren, die einen direkten Kontakt der ersten Oberfläche 11 mit einer anderen Oberfläche erfordern nicht behindert wird.

Die seitlichen Ätzradien 1102 in der Vertiefung 110 werden bei der Abscheidung nicht beschichtet, d.h. sie bleiben frei von elektrisch leitfähigem Material 4.

In einem weiteren Schritt, dessen Ergebnis in Fig. 1F veranschaulicht ist, entfernt ein Lift-Off-Prozess den Fotolack 3 ("Resist Strip") samt dem darauf angeordneten elektrisch leitfähigen Material 4., sodass das elektrisch leitfähige Material 4 lediglich in der Vertiefung 110 stehen bleibt.

Das Verfahren umfasst ferner das Entfernen der Ätzmaske 2, beispielsweise durch eine Chromätzung, falls die Ätzmaske 2 aus Chrom besteht. Das Entfernen des Fotolacks 3 und der Ätzmaske 2 kann gemäß einer Variante auch in einem Schritt erfolgen. Wie in Fig. 1G gezeigt, verbleibt somit im Ergebnis das in der Vertiefung 110 versenkte Metall 4 sowie, die Vertiefung 110 umgebend, die nun freiliegende erste Oberfläche 11 des ersten Substrats 1.

Die erste Oberfläche 11 ist dabei hinreichend sauber und glatt für ein anschließendes Direktbonden. So kann die erste Oberfläche nach dem Entfernen der Ätzmaske 2 beispielsweise eine Oberflächenrauheit von weniger als 0,5 nm aufweisen.

Fig. 1H veranschaulicht das Ergebnis eines anschließenden Prozessschritts, in welchem ein zweites Substrat 5 mittels Direktbonden an der ersten Oberfläche 11 befestigt wird. Das zweite Substrat 5 schließt die Vertiefung 110 nach Art eines Deckels nach oben hin ab. Damit zeigt die Fig. 1H einen Abschnitt einer Querschnittsansicht einer erfindungsgemäßen mikrofluidischen Vorrichtung 6.

Dabei kann vorgesehen sein, dass auch die beim Direktbonden verwendete Oberfläche des zweiten Substrats 5, eine Vertiefung aufweist (in Fig. 1H nicht dargestellt), wobei diese Oberfläche des zweiten Substrats 5 beim Direktbonden derart an der ersten Oberfläche 11 befestigt wird, dass die Vertiefung 110 des ersten Substrats 1 und die Vertiefung des zweiten Substrats 5 einander gegenüberliegen. So kann, wenn die versenkte Metallelektrode 4 wie gezeigt auf dem ersten Substrat 1 und ein Mikrofluidikkanal auf dem zweiten Substrat 5 untergebracht wird, ein direkter Kontakt zwischen einem Medium (Fluid) in dem Mikrofluidikkanal und der Metallelektrode 4 hergestellt werden.

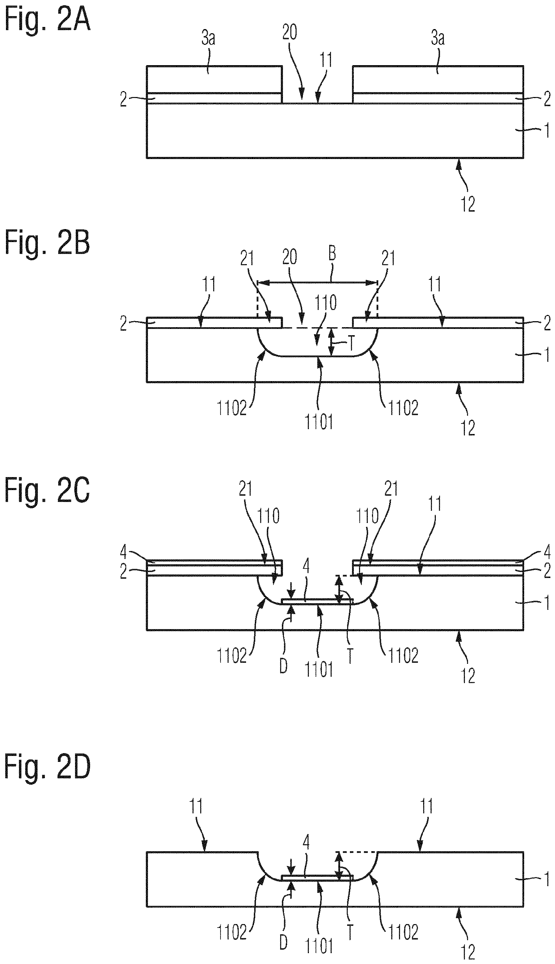

Die Fig. 2A-D veranschaulichen schematisch und beispielhaft eine weitere Variante. Dabei sind die in den Fig. 2A-B veranschaulichten Schritte identisch zu den mit Bezug auf Fig. 1A-B erläuterten. Insoweit wird auf das Vorstehende verwiesen. Im Anschluss daran kann jedoch - im Unterschied zu dem Ausführungsbeispiel gemäß Fig. 1A-H (dort insbesondere Fig. 1C-E) - auf die Verwendung des Fotolacks 3 verzichtet werden. Das Abscheiden des elektrisch leitfähigen Materials 4, beispielsweise Gold, kann dann demnach stattdessen direkt auf die Ätzmaske 2 (z. B. aus Chrom) erfolgen, wie in Fig. 2C verdeutlicht. Anschließend kann die Ätzmaske 2 mitsamt dem darauf abgeschiedenen leitfähigen Material 4 mittels einer Ätzung entfernt werden (Fig. 2D).

Die Ätzmaske 2 selbst (ohne Fotolack) hat bei dieser Variante demnach die Funktion einer "Lift-off-Barriere" für das elektrisch leitfähige Material 4. Hierfür ist es vorteilhaft, wenn die Schichtdicke D des elektrisch leitfähigen Materials 4 kleiner oder gleich einer Schichtdicke der Ätzmaske 2 ist und damit ein Ätzen der Ätzmaske 2 erlaubt, wenn das elektrisch leitfähige Material 4 bereits darauf abgeschieden ist. Begünstigt wird ein solcher Lift-off-Prozess ferner, wenn viele Kanäle 110 vorhanden sind, die ein lokales Unterwandern der elektrisch leitfähigen Schicht 4 durch ein Ätzmittel und damit einen Angriff auf die Ätzmaske 2 erlauben.

### Bezugszeichenliste

- 1: Erstes Substrat
- 11: Erste Oberfläche
- 110: Vertiefung / Kanal
- 1101: Boden
- 1102: Rundungen
- 12: Zweite Oberfläche

- 2: Ätzmaske
- 20: Öffnung
- 21: Randabschnitte
- 3, 3a: Fotolack
- 3b: Belichteter Abschnitt

- 4: Elektrisch leitfähiges Material

- 5: Zweites Substrat

- 6: Mikrofluidische Vorrichtung

- B: Breite
- D: Schichtdicke des elektrisch leitfähigen Materials
- L: Licht
- T: Tiefe

## Patentansprüche

1. Verfahren zur Fertigung einer mikrofluidischen Vorrichtung (6), umfassend die folgenden Schritte:
- Bereitstellen eines ersten Substrats (1) mit einer ersten Oberfläche (11) und einer der ersten Oberfläche (11) gegenüberliegenden zweiten Oberfläche (12);
- Erzeugen einer Ätzmaske (2) auf der ersten Oberfläche (11), wobei die Ätzmaske (2) eine Öffnung (20) aufweist;
- Erzeugen, mittels einer Ätzung, einer Vertiefung (110) in der ersten Oberfläche (11) im Bereich der Öffnung (20);
- Abscheiden eines elektrisch leitfähigen Materials (4) auf die Ätzmaske (2) und/oder eine die Ätzmaske (2) bedeckende Schicht (3) sowie auf einen Bereich eines Bodens (1101) der Vertiefung (110) unterhalb der Öffnung (20),
**dadurch gekennzeichnet, dass** das Verfahren vor dem Abscheiden des elektrisch leitfähigen Materials (4) die folgenden Schritte umfasst:
- Auftragen eines Fotolacks (3, 3b) auf die Ätzmaske (2) und auf einen Bereich des Bodens (1101) der Vertiefung (110) unterhalb der Öffnung (20);
- Entfernen des Fotolacks (3b) aus der Vertiefung (110), wobei das elektrisch leitfähige Material (4) danach auf den die Ätzmaske (2) bedeckenden Fotolack (3) und auf den Bereich des Bodens (1101) der Vertiefung (110) unterhalb der Öffnung (20) abgeschieden wird; und wobei
o das Entfernen des Fotolacks (3b) aus der Vertiefung (110) eine Belichtung des Fotolacks (3b) in der Vertiefung (110) umfasst, wobei die Belichtung durch die zweite Oberfläche (12) hindurch erfolgt;
o das erste Substrat (1) für Licht (L), das für eine Belichtung des Fotolacks (3, 3b) geeignet ist, transparent ist; und
o die Ätzmaske (2) für Licht (L), das für eine Belichtung des Fotolacks (3, 3b) geeignet ist, intransparent ist.

2. Verfahren nach Anspruch 1, **dadurch gekennzeichnet, dass** die Ätzmaske (2) beim Erzeugen der Vertiefung (110) wenigstens teilweise seitlich unterätzt wird, sodass wenigstens ein seitlicher Randabschnitt (21) der Ätzmaske (2) über einen Rand der Vertiefung (110) hinaus übersteht.

3. Verfahren nach einem der vorstehenden Ansprüche, **dadurch gekennzeichnet, dass** das erste Substrat (1) aus Glas, Quartz oder Silizium besteht.

4. Verfahren nach einem der vorstehenden Ansprüche, **dadurch gekennzeichnet, dass** das Verfahren ferner das Entfernen der Ätzmaske (2) umfasst.

5. Verfahren nach Anspruch 4, **dadurch gekennzeichnet, dass** die erste Oberfläche (11) nach dem Entfernen der Ätzmaske (2) eine Oberflächenrauheit von weniger als 0,5 nm aufweist.

6. Verfahren nach einem der vorstehenden Ansprüche, **dadurch gekennzeichnet, dass** eine Schichtdicke (D) des elektrisch leitfähigen Materials (4) in der Vertiefung (110) nicht größer als eine Tiefe (T) der Vertiefung (110) ist.

7. Verfahren nach einem der vorstehenden Ansprüche, **dadurch gekennzeichnet, dass** ein zweites Substrat (5) mittels Waferbonden, insbesondere Direktbonden, an der ersten Oberfläche (11) befestigt wird.

8. Verfahren nach einem der vorstehenden Ansprüche, **dadurch gekennzeichnet, dass** eine Oberfläche des zweiten Substrats (5), eine Vertiefung aufweist, wobei die Oberfläche des zweiten Substrats (5) derart an der ersten Oberfläche (11) befestigt wird, dass die Vertiefung (110) des ersten Substrats (1) und die Vertiefung des zweiten Substrats (5) einander gegenüberliegen.

## Claims

1. Method for manufacturing a microfluidic device (6), comprising the following steps:
- providing a first substrate (1) having a first surface (11) and a second surface (12) lying opposite the first surface (11);
- producing an etching mask (2) on the first surface (11), wherein the etching mask (2) has an opening (20);
- producing, by means of etching, a recess (110) in the first surface (11) in the region of the opening (20);
- depositing an electrically conductive material (4) onto the etching mask (2) and/or a layer (3) covering the etching mask (2) and onto a region of a bottom (1101) of the recess (110) below the opening (20),
**characterized in that** the method comprises the following steps before the depositing of the electrically conductive material (4):
- applying a photoresist (3, 3b) to the etching mask (2) and to a region of a bottom (1101) of the recess (110) below the opening (20);
- removing the photoresist (3b) from the recess (110), wherein the electrically conductive material (4) is then deposited onto the photoresist (3) covering the etching mask (2) and onto the region of the bottom (1101) of the recess (110) below the opening (20); and wherein
o the removal of the photoresist (3b) from the recess (110) comprises exposing the photoresist (3b) in the recess (110), wherein the exposure takes place through the second surface (12);
o the first substrate (1) is transparent to light (L) suitable for an exposure of the photoresist (3, 3b); and
o the etching mask (2) is not transparent to light (L) that is suitable for the exposure of the photoresist (3, 3b).

2. Method according to Claim 1, **characterized in that** the etching mask (2) is at least partially undercut laterally when the recess (110) is produced such that at least one lateral edge portion (21) of the etching mask (2) protrudes beyond an edge of the recess (110) .

3. Method according to one of the preceding claims, **characterized in that** the first substrate (1) consists of glass, quartz or silicon.

4. Method according to one of the preceding claims, **characterized in that** the method also comprises the removal of the etching mask (2).

5. Method according to Claim 4, **characterized in that** the first surface (11) has a surface roughness of less than 0.5 nm after the removal of the etching mask (2).

6. Method according to one of the preceding claims, **characterized in that** a layer thickness (D) of the electrically conductive material (4) in the recess (110) is no greater than a depth (T) of the recess (110) .

7. Method according to one of the preceding claims, **characterized in that** a second substrate (5) is attached to the first surface (11) by means of wafer bonding, in particular direct bonding.

8. Method according to one of the preceding claims, **characterized in that** a surface of the second substrate (5) has a recess, wherein the surface of the second substrate (5) is attached to the first surface (11) such that the recess (110) of the first substrate (1) and the recess of the second substrate (5) lie opposite one another.

## Revendications

1. Procédé de fabrication d'un dispositif microfluidique (6), ledit procédé comprenant les étapes suivantes :
- fournir un premier substrat (1) comportant une première surface (11) et une deuxième surface (12) opposée à la première surface (11) ;
- générer un masque de gravure (2) sur la première surface (11), le masque de gravure (2) comportant une ouverture (20) ;
- réaliser, par gravure, une dépression (110) dans la première surface (11) au niveau de l'ouverture (20) ;
- déposer un matériau électriquement conducteur (4) sur le masque de gravure (2) et/ou une couche (3), recouvrant le masque de gravure (2), ainsi que sur une zone d'un fond (1101) de la dépression (110) au-dessous de l'ouverture (20),
**caractérisé en ce que,** avant de déposer le matériau électriquement conducteur (4), le procédé comprend les étapes suivantes :
- appliquer un vernis photosensible (3, 3b) sur le masque de gravure (2) et sur une zone du fond (1101) de la dépression (110) au-dessous de l'ouverture (20) ;
- retirer le vernis photosensible (3b) de la dépression (110), le matériau électriquement conducteur (4) étant ensuite déposé sur le vernis photosensible (3), recouvrant le masque de gravure (2), et sur la zone du fond (1101) de la dépression (110) au-dessous de l'ouverture (20) ; et
o le retrait du vernis photosensible (3b) de la dépression (110) comprenant une insolation du vernis photosensible (3b) dans la dépression (110), l'insolation étant effectuée à travers la deuxième surface (12) ;
o le premier substrat (1) étant transparent à la lumière (L) qui est appropriée à l'insolation du vernis photosensible (3, 3b) ; et
o le masque de gravure (2) n'étant pas transparent à la lumière (L) qui est appropriée à l'insolation du vernis photosensible (3, 3b).

2. Procédé selon la revendication 1, **caractérisé en ce que** le masque de gravure (2) est au moins partiellement creusé latéralement lors de la réalisation de la dépression (110) de sorte qu'au moins une portion de bord latéral (21) du masque de gravure (2) fait saillie d'un bord de la dépression (110).

3. Procédé selon l'une des revendications précédentes, **caractérisé en ce que** le premier substrat (1) est en verre, en quartz ou en silicium.

4. Procédé selon l'une des revendications précédentes, **caractérisé en ce que** le procédé comprend en outre le retrait du masque de gravure (2).

5. Procédé selon la revendication 4, **caractérisé en ce que,** après le retrait du masque de gravure (2), la première surface (11) présente une rugosité de surface inférieure à 0,5 nm.

6. Procédé selon l'une des revendications précédentes, **caractérisé en ce qu'**une épaisseur de couche (D) du matériau électriquement conducteur (4) dans la dépression (110) n'est pas supérieure à la profondeur (T) de la dépression (110).

7. Procédé selon l'une des revendications précédentes, **caractérisé en ce qu'**un deuxième substrat (5) est fixé à la première surface (11) par métallisation de plaquette, notamment métallisation directe.

8. Procédé selon l'une des revendications précédentes, **caractérisé en ce qu'**une surface du deuxième substrat (5) comporte une dépression, la surface du deuxième substrat (5) étant fixée à la première surface (11) de manière à ce que la dépression (110) du premier substrat (1) et la dépression du deuxième substrat (5) soient opposées l'une à l'autre.
